# FASCICULE DE BREVET EUROPEEN

(11) **EP 1 518 145 B1**
(45) Date de publication et mention de la délivrance du brevet: **14.12.2005**
(21) Numéro de dépôt: 03740263.3
(22) Date de dépôt: 17.06.2003
(51) Int. Cl.: G02F 1/1345, G02F 1/13

(54) **CELLULE D AFFICHAGE, NOTAMMENT A CRISTAL LIQUIDE, OU CELLULE PHOTOVOLTAIQUE COMPRENANT DES MOYENS POUR SA CONNEXION A UN CIRCUIT ELECTRONIQUE DE COMMANDE**
ANZEIGEZELLE, INSBESONDERE FLÜSSIGKRISTALL- ODER PHOTOVOLTAISCHE ZELLE MIT MITTELN ZUR VERBINDUNG MIT EINER ELEKTRONISCHEN STEUERSCHALTUNG
DISPLAY CELL, IN PARTICULAR LIQUID CRYSTAL, OR PHOTOVOLTAIC CELL COMPRISING MEANS FOR CONNECTION TO AN ELECTRONIC CONTROL CIRCUIT

(30) Priorité: 21.06.2002 EP 02077490
(43) Date de publication de la demande: 30.03.2005
(73) Titulaire: ASULAB S.A., 2074 Marin (CH)
(72) Inventeur: GRUPP, Joachim, CH-2073 Enges (CH); KLAPPERT, Rolf, CH-2000 Neuchâtel (CH)
(74) Mandataire: Thérond, Gérard Raymond
(86) Numéro de dépôt international: PCT/EP2003/006376
(87) Numéro de publication internationale: WO 2004/001495

(56) Documents cités:
- US-A- 4 025 162
- PATENT ABSTRACTS OF JAPAN vol. 005, no. 138 (P-078), 2 septembre 1981 (1981-09-02) -& JP 56 075624 A (CASIO COMPUT CO LTD), 22 juin 1981 (1981-06-22)
- PATENT ABSTRACTS OF JAPAN vol. 006, no. 053 (P-109), 8 avril 1982 (1982-04-08) -& JP 56 168628 A (CASIO COMPUT CO LTD), 24 décembre 1981 (1981-12-24)
- PATENT ABSTRACTS OF JAPAN vol. 1996, no. 01, 31 janvier 1996 (1996-01-31) -& JP 07 249555 A (OKI ELECTRIC IND CO LTD;OTHERS: 01), 26 septembre 1995 (1995-09-26)

## Description

La présente invention concerne un dispositif délimitant un volume pour le confinement d'un fluide tel qu'un cristal liquide et, plus généralement, d'une matière sensible susceptible de changer de propriétés physiques, notamment optiques, sous l'effet de l'application d'une tension, ou de propriétés électriques sous l'effet d'une contrainte ou d'un rayonnement. En particulier, la présente invention concerne un tel dispositif d'affichage comprenant des moyens pour sa connexion à un circuit électronique de commande.

Dans son acception la plus simple, une cellule à cristal liquide se compose pour l'essentiel d'un substrat avant transparent et d'un substrat arrière également transparent ou non, ces deux substrats étant réunis et maintenus à distance constante l'un de l'autre par un cadre de scellement qui délimite un volume étanche pour le confinement du cristal liquide. Par ailleurs, les substrats avant et arrière comportent chacun, sur leurs faces en regard, au moins une électrode, ces électrodes étant destinées à être reliées à un circuit électronique de commande qui, par application sélective de tensions appropriées à des électrodes déterminées, permet de modifier les propriétés optiques du cristal liquide au point de croisement des électrodes considérées.

Un problème constant dans le domaine de la fabrication des cellules à cristaux liquides du genre décrit ci-dessus est posé par les moyens de connexion destinés à établir la liaison électrique entre les électrodes de la cellule et le circuit de commande. Une technique simple pour procéder à la connexion électrique entre les électrodes et le circuit de commande consiste à décaler les substrats l'un par rapport à l'autre, si bien que l'on peut accéder à une partie plane des électrodes et réaliser aisément la connexion sur la surface ainsi dégagée. Un tel agencement des substrats rend cependant la fabrication des cellules en série difficile, notamment lorsque celles-ci sont circulaires, et nécessite des opérations supplémentaires coûteuses en temps. Les cellules résultantes sont, en outre, de plus grandes dimensions et donc difficiles à loger dans des objets électroniques portatifs de petites dimensions tels qu'une montre-bracelet.

Une autre solution au problème susmentionné a été proposée par la Demanderesse dans la demande internationale publiée sous le numéro WO 99/41638. On connaît, en effet, par cette demande, une cellule électro-optique telle qu'une cellule à cristal liquide, ou une cellule photovoltaïque électrochimique, ces cellules se composant chacune d'un substrat avant transparent, d'un substrat arrière également transparent ou non, un cadre de scellement réunissant les deux substrats et définissant un volume pour le confinement étanche d'un milieu photoélectriquement ou électro-optiquement actif, les substrats comportant sur leurs faces en regard au moins une électrode. Ces cellules se distinguent par le fait que leurs électrodes viennent partiellement affleurer le bord du substrat sur lequel elles sont déposées pour définir des zones de contact électrique latérales à hauteur desquelles sont rapportées des pièces en forme d'équerre qui permettent avantageusement de reporter le contact électrique sur la face arrière desdites cellules.

Grâce à ces caractéristiques, il n'est plus nécessaire de prévoir de décalage entre les deux substrats d'une cellule pour pouvoir établir la connexion électrique entre les électrodes de ladite cellule et son circuit de commande, de sorte que ces substrats peuvent être prévus identiques et disposés l'un au dessus de l'autre à recouvrement. On aboutit ainsi à une grande simplicité de fabrication des cellules, et donc à une diminution sensible de leur prix de revient. D'autre part, l'encombrement des cellules est réduit, ce qui facilite leur montage notamment dans une pièce d'horlogerie.

La solution décrite ci-dessus présente cependant un inconvénient. En effet, les pièces de contact électrique, réalisées en métal ou en un alliage métallique conducteur de l'électricité, constituent des éléments discrets qu'il est nécessaire de coller les uns après les autres au moyen d'une colle conductrice sur la tranche de la cellule, aux endroits où les électrodes affleurent le bord du substrat sur lequel elles sont disposées. Un tel procédé de fabrication, s'il s'avère relativement simple à mettre en oeuvre dans le cas d'une cellule photovoltaïque électrochimique qui ne comporte que deux électrodes, s'avère beaucoup plus compliqué à utiliser dans le cas des cellules à cristal liquide qui, lorsqu'elles sont de type matriciel, peuvent comporter plusieurs centaines d'électrodes et de contre-électrodes auxquelles il faudrait, à chaque fois, associer une pièce de report du contact électrique. Bien entendu, le procédé de fabrication pourrait être automatisé, mais le nombre et la précision avec laquelle les pièces de contact électrique devraient être rapportées sur la tranche des cellules renchériraient considérablement les coûts de fabrication de telles cellules.

Pour remédier à ce problème, on connaît les documents JP 56 075624 et JP 56 168628 sur lesquels est basé le préambule de la première revendication, et qui décrivent tous deux des cellules à cristaux liquides sur la tranche et la face arrière desquelles des pistes conductrices sont déposées par impression.

Grâce à ces caractéristiques, les substrats des cellules d'affichage peuvent être de dimensions sensiblement égales et ne nécessitent plus d'être décalés l'un par rapport à l'autre pour permettre l'établissement des connexions électriques entre les électrodes et le circuit de commande. Ainsi, si, pour de mêmes dimensions externes, la surface active d'une cellule à cristal liquide peut être augmentée, on peut augmenter la résolution de l'afficheur, c'est-à-dire prévoir un nombre plus important d'électrodes de lignes et de colonnes, sans que l'ouverture ou aperture des pixels, et donc la réflectivité de la cellule d'affichage, ne soient altérées. Inversement, on peut mettre à profit l'augmentation de la surface active de la cellule d'affichage pour, à nombre constant d'électrodes de lignes et de colonnes, augmenter la largeur desdites électrodes et donc augmenter l'aperture des pixels, ce qui a un effet favorable sur la réflectivité de l'afficheur.

Les résultats décrits ci-dessus sont atteints grâce au fait que les moyens pour relier les électrodes d'une cellule d'affichage à un circuit de commande ne sont pas formés par des pièces de contact qu'il serait nécessaire de coller une à une, mais par des pistes conductrices qui permettent de reporter les contacts électriques formés par les électrodes d'une cellule depuis la tranche de la cellule jusqu'au bord arrière de ladite cellule, puis, de là, autour dudit bord arrière et jusque sur le dos de la cellule, ces pistes conductrices étant formées sur la tranche et l'arrière de la cellule par toute technique appropriée de dépôt et de gravure de couches conductrices permettant d'atteindre les dimensions et la résolution recherchées.

On peut cependant craindre que les pistes conductrices, qui sont déposées sous forme de couches minces, présentent des problèmes de fiabilité et de continuité de la conduction électrique à l'endroit où elles épousent le bord arrière, souvent aigu, de la cellule. En effet, les contraintes thermiques qui apparaissent au cours du procédé de fabrication des cellules peuvent provoquer le déchirement des pistes conductrices au niveau du bord du substrat arrière de la cellule. De même, une couche mince déposée autour du bord arrière de la cellule présente une faible tenue mécanique et peut être facilement rayée et interrompue lorsqu'on manipule la cellule ou qu'on veut la monter dans l'objet portatif auquel elle est destinée.

La présente invention a pour but de remédier aux problèmes susmentionnés ainsi qu'à d'autres encore en procurant un dispositif d'affichage, notamment à cristal liquide, comprenant des moyens pour la connexion de ses électrodes à un circuit électronique de commande qui soient à la fois simples à fabriquer et fiables.

A cet effet, la présente invention concerne une cellule d'affichage électro-optique, en particulier à cristaux liquides, ou une cellule photovoltaïque électrochimique comprenant :
- au moins un substrat avant transparent dont la surface supérieure constitue la face avant de la cellule;
- au moins un substrat arrière également transparent ou non dont la surface inférieure constitue la face arrière de ladite cellule;
- un cadre de scellement réunissant les substrats avant et arrière et délimitant un volume pour le confinement étanche d'un milieu électro-optiquement ou photoélectriquement actif;
- lesdits substrats avant et arrière comportant sur leurs faces en regard au moins une électrode chacun, ces électrodes reliées à des pistes conductrices elles-mêmes destinées à être reliées à un circuit électrique d'alimentation ou de commande et venant définir des zones de contact électrique latérales,
cette cellule étant caractérisée en ce que les pistes conductrices se composent chacune d'une première partie en contact avec les électrodes à hauteur des zones de contact électrique latérales, et d'une seconde partie s'étendant sur la surface arrière de la cellule, des moyens de contact ménagés de façon continue ou discontinue le long d'une partie au moins du contour arrière de la cellule sur la tranche et/ou sur la face arrière de ladite cellule assurant la jonction électrique entre les premières et les deuxièmes parties des pistes conductrices.

Selon une variante, ces moyens de contact se présentent sous la forme de plots discrets.

Grâce à ces caractéristiques, des plots conducteurs sont disposés sur au moins une partie du pourtour arrière de la cellule, de façon à remplacer l'agencement des pistes conductrices autour du bord arrière de la cellule par une prise de contact latérale sur les faces opposées des plots conducteurs beaucoup plus fiable et plus résistante du point de vue mécanique.

Dans son acception la plus générale, la présente invention concerne une cellule comprenant un empilement de (n) cellules individuelles (où n est un nombre entier naturel supérieur ou égal à 2), chacune des cellules individuelles étant délimitée par deux substrats qui lui sont propres, ou bien une cellule comprenant (n+1) substrats superposés (où n est un nombre entier supérieur ou égal à 1), ces (n+1) substrats étant réunis deux à deux par un cadre de scellement.

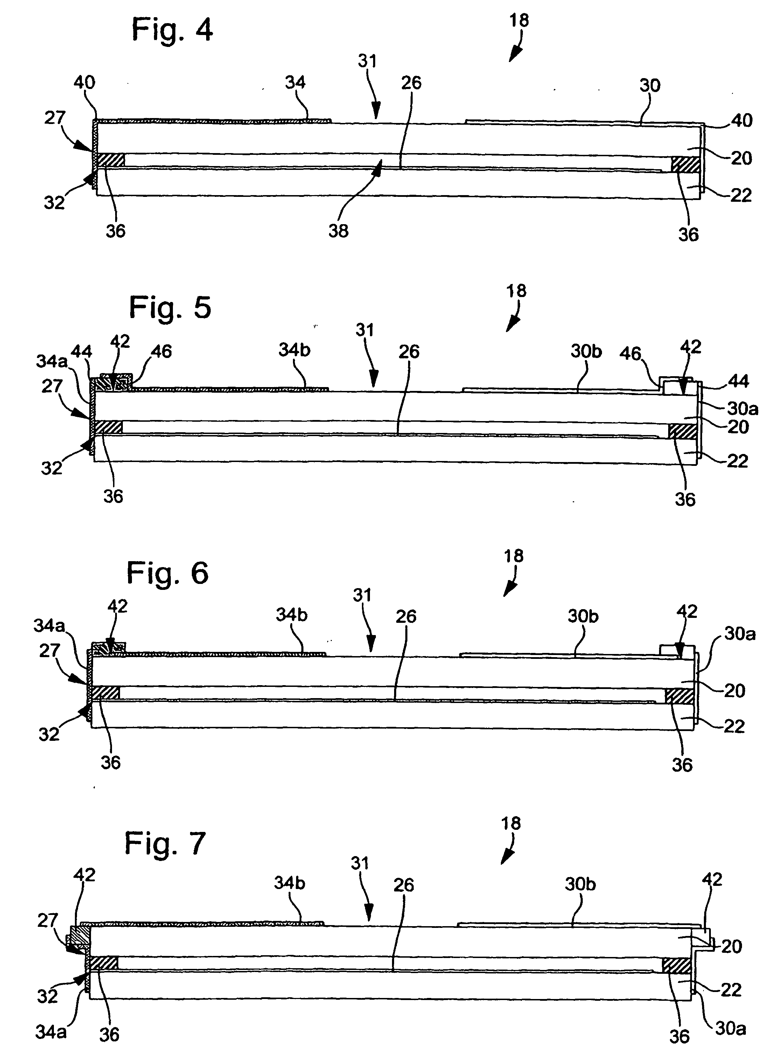

D'autres caractéristiques et avantages de la présente invention ressortiront plus clairement de la description détaillée qui suit pour laquelle un mode de réalisation d'une cellule selon l'invention est détaillé en relation avec les figures 5 à 13, cet exemple étant donné à titre purement illustratif et non limitatif seulement
- la figure 1 est une vue générale en perspective à l'endroit d'une cellule d'affichage à cristal liquide multicouche;
- la figure 2 est une vue générale en perspective à l'envers de la cellule multicouche représentée à la figure 1;
- la figure 3 est une vue schématique en perspective et en transparence d'une cellule d'affichage à cristal liquide comprenant deux substrats;
- la figure 4 est une vue en coupe longitudinale de la cellule d'affichage représentée à la figure 3;
- la figure 5 est une vue en coupe d'une cellule d'affichage à cristal liquide selon l'invention;
- la figure 6 est une vue en coupe d'une variante d'exécution de la cellule d'affichage à cristal liquide représentée à la figure 5;
- la figure 7 est une vue en coupe d'une autre variante d'exécution de la cellule d'affichage à cristal liquide représentée à la figure 5;
- la figure 8 est une vue schématique illustrant le procédé de métallisation d'une cellule à cristal liquide selon l'invention;
- la figure 9 est une vue en coupe d'une cellule à cristal liquide conforme à l'invention sur le dos de laquelle a été directement monté un circuit de commande;
- la figure 10 est une vue analogue à celle de la figure 9, le circuit de commande étant monté par l'intermédiaire d'une plaquette de circuit imprimé sur le dos de la cellule;
- la figure 11 est une vue analogue à celle de la figure 9, le circuit de commande étant monté par l'intermédiaire d'un film conducteur souple sur le dos de la cellule;
- la figure 12 est une vue analogue à celle de la figure 9, une couche absorbante de relaxation des contraintes ayant été déposée sur la face arrière de la cellule, et
- la figure 13 est une vue en perspective d'une cellule à cristal liquide munie d'une bande de matériau conducteur anisotrope assurant la jonction entre les premières et les secondes parties des pistes conductrices.

La présente invention va être décrite en liaison avec une cellule d'affichage à cristal liquide. Il va de soi que la présente invention n'est pas limitée à un tel type de cellule, et qu'elle pourra s'appliquer à tout type de cellule comprenant un milieu sensible susceptible de changer de propriétés physiques, notamment optiques, sous l'effet de l'application d'une tension, ou de propriétés électriques sous l'effet d'une contrainte ou d'un rayonnement.

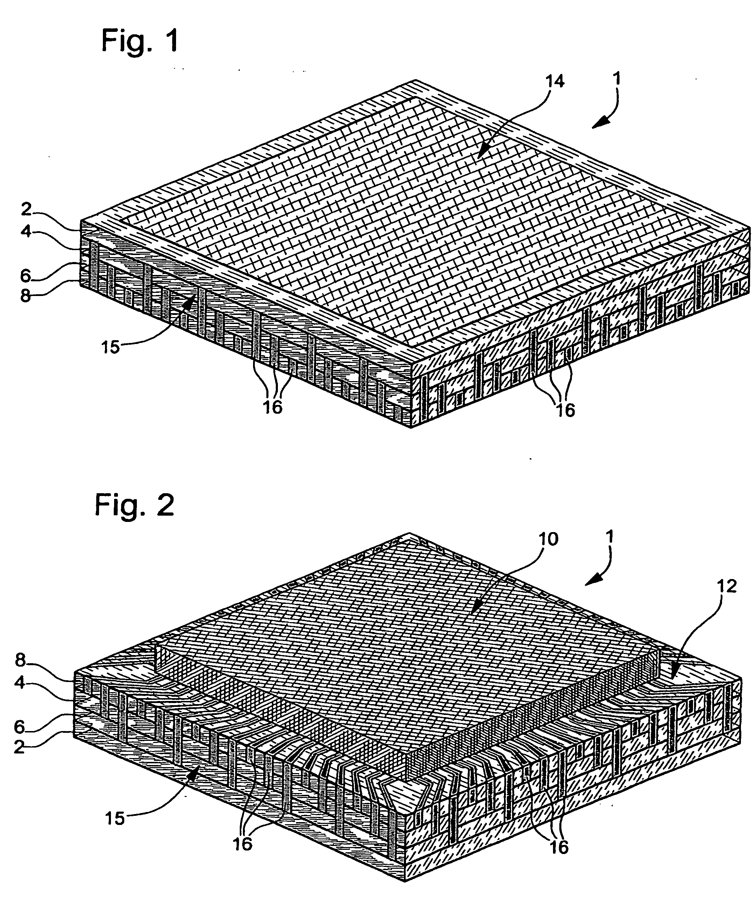

Les figures 1 et 2 sont des vues en perspective, respectivement à l'endroit et à l'envers, d'une cellule d'affichage multicouche à cristaux liquides non revendiquée. Désignée dans son ensemble par la référence numérique générale 1, cette cellule d'affichage comprend quatre substrats superposés 2, 4, 6 et 8 qui peuvent être réalisés en verre ou en un autre matériau transparent tel que du plastique. On notera que le dernier substrat 8 peut être transparent ou non selon la nature réflective ou transmissive de la cellule d'affichage 1. Dans le cas présent, comme un circuit intégré 10 de commande de l'affichage de la cellule 1 est monté sur le dos 12 de ladite cellule 1 (voir figure 2), on a affaire à une cellule de type réflectif et le substrat arrière 8 pourra être opaque ou recouvert d'une couche d'un matériau opacifiant afin de masquer le circuit intégré 10 à la vue d'un observateur situé du côté avant 14 de la cellule 1.

Les substrats 2 à 8 sont réunis deux à deux par des cadres de scellement (non visibles sur les figures 1 et 2) qui délimitent chacun une cavité étanche pour le confinement des cristaux liquides. Plus précisément, un premier cadre de scellement réunit les substrats 2 et 4, tandis qu'un second cadre de scellement réunit les substrats 4 et 6 et qu'un troisième et dernier cadre de scellement réunit les substrats 6 et 8.

Comme cela ressortira plus clairement dans la suite de la description, les électrodes de la cellule 1 viennent affleurer la tranche 15 de la cellule 1 en des endroits distincts de son périmètre pour y définir des zones de contact électrique latérales. Des pistes conductrices 16 qui viennent en contact avec les électrodes au niveau des zones de contact électrique latérales sont formées directement sur la tranche 15 et le dos 12 de la cellule 1, de façon à reporter tous les contacts électriques dans le même plan arrière de ladite cellule 1. Les pistes conductrices 16 s'étendent donc depuis les électrodes de la cellule 1 jusqu'aux ports d'entrée du circuit intégré 10 de commande de l'affichage qui est monté sur le dos 12 de la cellule 1 par des techniques qui seront décrites en détail ultérieurement. Sur les figures 1 et 2, on voit que les pistes conductrices ne sont pas de longueurs égales et s'arrêtent juste aux endroits où les électrodes viennent affleurer la tranche de la cellule. Il va de soi que les pistes conductrices ont été ainsi représentées afin de mieux faire comprendre la façon dont les connections électriques s'établissent entre les électrodes et lesdites pistes conductrices mais, que dans la pratique, on préférera réaliser des pistes conductrices de longueurs identiques.

Il n'est donc pas nécessaire de prévoir de décalage entre les substrats d'une cellule pour pouvoir accéder aux électrodes de celle-ci et établir les connexions électriques avec un circuit d'alimentation ou de commande. Ainsi, cette surface périphérique qui est normalement dévolue à la connexion de la cellule et qui, proportionnellement, empiète d'autant plus sur la surface active de la cellule que cette dernière est petite, peut être supprimée. Ceci s'avère particulièrement avantageux lorsque, pour une même surface active de la cellule, le nombre d'électrodes de lignes et de colonnes augmente. En effet, dans ce cas, la largeur des électrodes diminue, et pour maintenir constante la surface des plages de contact électrique, il faudrait allonger les électrodes, ce qui aurait pour effet d'augmenter la zone non active autour de la cellule d'affichage.

La suppression de la zone périphérique normalement réservée à l'adressage d'une cellule d'affichage à cristal liquide ne permet pas seulement d'améliorer le rapport, mieux connu sous sa dénomination anglo-saxonne "aspect ratio", entre les zones active et non active d'une telle cellule. Il permet également de s'affranchir d'un système complexe et encombrant de circuits imprimés souples qui sont habituellement collés sur le pourtour de la cellule et qui permettent de relier les différents circuits de commande qu'ils portent aux électrodes de ladite cellule.

Jusqu'à présent, on a décrit une cellule à plusieurs couches. Néanmoins, par souci de clarté, on se référera dans tout ce qui va suivre à une cellule d'affichage comprenant seulement deux substrats entre lesquels est emprisonnée une unique couche de cristal liquide.

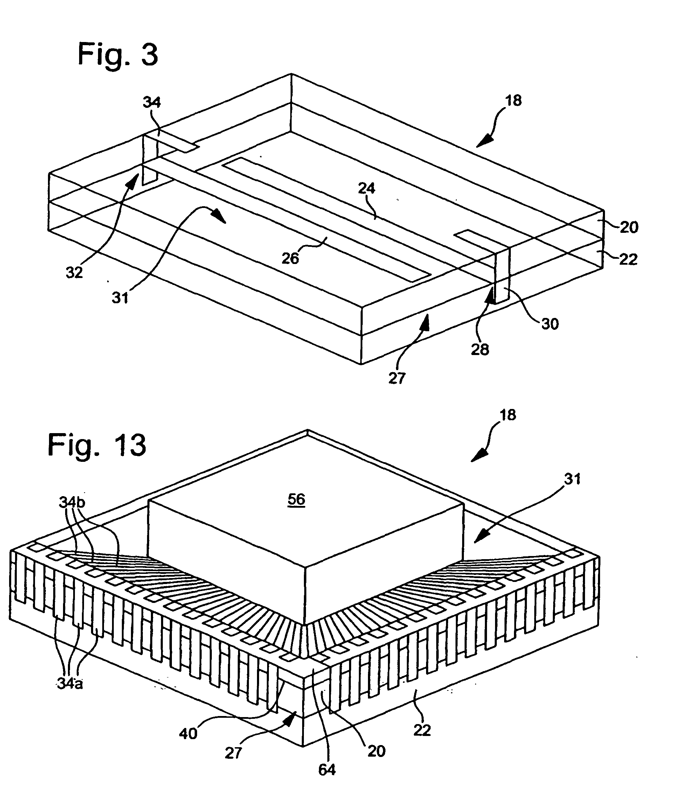

La figure 3 est une vue schématique en perspective et en transparence d'une cellule à cristal liquide 18 non revendiquée comprenant deux substrats 20 et 22 qui peuvent être réalisés en verre ou en un autre matériau transparent tel que du plastique. Les substrats 20 et 22 sont réunis entre eux par un cadre de scellement qui délimite un volume étanche pour le confinement des cristaux liquides. Seules deux électrodes 24 et 26 ont été représentées au dessin. Il va toutefois de soi qu'en réalité la cellule 18 comporte une multiplicité d'électrodes qui sont formées sur les faces en regard des substrats 20 et 22. Comme on peut le constater, l'électrode 24 s'étend sur sensiblement la longueur totale du substrat 20 sur lequel elle a été déposée et vient, à l'une de ses extrémités, affleurer la tranche 27 dudit substrat 20 pour y définir une zone 28 de contact électrique latérale. Une piste conductrice 30 qui est formée sur la tranche 27 et le dos 31 de la cellule 18 vient en contact avec l'électrode 24 au niveau de la zone de contact 28, de façon à reporter le contact électrique dans le plan arrière de ladite cellule 18. Il en va de même avec l'électrode 26 qui définit une zone de contact 32 au niveau de laquelle est formée une piste conductrice 34.

La figure 4 est une vue en coupe longitudinale de la cellule à cristal liquide 18 non revendiquée représentée à la figure 3. On voit sur cette figure le cadre de scellement 36 qui définit le volume 38 pour le confinement du cristal liquide. Les électrodes 24 et 26 passent sous le cadre de scellement 36 et viennent affleurer la tranche 27 du substrat 20 sur lequel elles ont été formées pour définir les zones de contact électrique latérales respectivement 28 et 32. Les pistes conductrices 30 et 34 permettent de reporter les contacts électriques formés par les électrodes 24 et 26 de la cellule à cristal liquide 18 depuis la tranche 27 de la cellule 18 jusqu'au bord ou arête arrière 40 de ladite cellule, puis, de là, autour dudit bord arrière 40 et jusque sur le dos 31 de la cellule 18.

Les pistes conductrices 30 et 34 sont formées par dépôt de couches minces d'un matériau électriquement conducteur comme cela sera décrit en détail ultérieurement. On peut, par conséquent, craindre que les pistes conductrices présentent des problèmes de tenue à la chaleur et aux contraintes mécaniques et se déchirent aux endroits où elles épousent le bord arrière 40, souvent aigu, de la cellule, lors de la fabrication de la cellule ou lorsqu'on manipule cette dernière. C'est pourquoi, selon le mode de réalisation illustré aux figures 5 et 6, on forme le long du bord arrière 40 de la cellule des plots conducteurs 42 destinés à assurer la continuité des pistes conductrices 30 et 34.

En effet, comme cela est visible sur la figure 5, les pistes conductrices 30 et 34 se composent chacune d'une première partie, respectivement 30a et 34a, qui s'étend sur au moins une partie de la tranche 27 de la cellule 18, et d'une seconde partie, respectivement 30b et 34b, qui s'étend sur au moins une partie du dos 31 de la cellule 18, les plots conducteurs 42 assurant la jonction électrique entre les premières et les secondes parties desdites pistes conductrices 30 et 34. Plus précisément, les premières parties 30a et 34a des pistes conductrices 30 et 34 viennent latéralement en contact avec les plots conducteurs 42, tandis que les secondes parties 30b et 34b desdites pistes conductrices 30 et 34 peuvent s'étendre jusqu'à la cime desdits plots 42 et même les recouvrir partiellement. De la sorte, on remplace l'agencement des pistes conductrices 30, 34 autour du bord arrière 40 de la cellule 18 par une prise de contact latérale sur les faces opposées 44 et 46 des plots conducteurs 42.

Selon une variante de réalisation représentée à la figure 6, les secondes parties 30b et 34b des pistes conductrices 30 et 34 s'étendent au moins partiellement sous les plots conducteurs 42.

Selon une autre variante de réalisation représentée à la figure 7, au moins certains des plots 42 peuvent être ménagés sur la tranche 27 de la cellule 18.

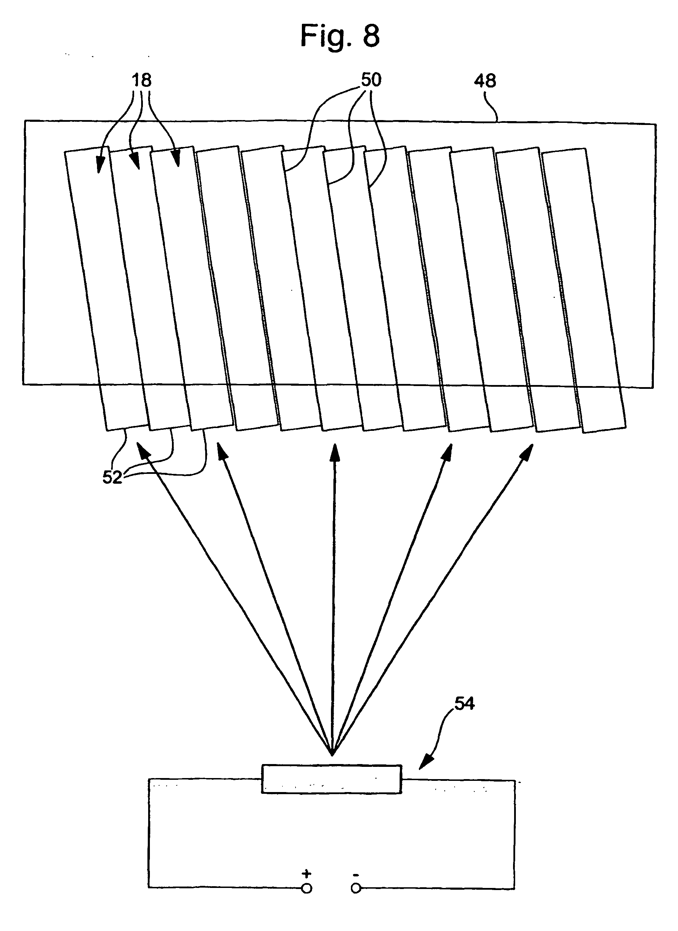

Pour former les pistes conductrices qui permettent de reporter les contacts électriques formés par les électrodes d'une cellule sur le dos de cette dernière; on procède de la façon suivante. Une fine couche de matériau conducteur est évaporée sur le dos des cellules alors que celles-ci sont encore en lot ou en batch. Après individualisation des cellules, un groupe d'entre elles est disposé dans un support ou posage 48 (voir figure 8). Les cellules sont disposées parallèlement entre elles en oblique et légèrement décalées les unes par rapport aux autres, de sorte que leurs grands côtés 50 sont parallèles et que leurs petits côtés 52 qui sont destinés à être métallisés sont disposés de façon décalée en escalier. Une source d'évaporation 54 d'un matériau électriquement conducteur est disposée en regard du posage 48, face aux tranches 52 des cellules à métalliser.

Après métallisation du dos 31 et de la tranche 27 des cellules, il faut structurer les pistes conductrices, par exemple par ablation laser. Par souci d'économie et afin d'obtenir un meilleur rendement, seules les premières parties 30a, 34a des pistes conductrices 30, 34 qui s'étendent sur la tranche 27 des cellules à cristal liquide 18 seront structurées par ablation laser, tandis que les secondes parties 30b, 34b de ces mêmes pistes conductriques 30, 34 qui s'étendent au dos 31 des cellules 18 pourront être structurées par des techniques de photolithographie classiques.

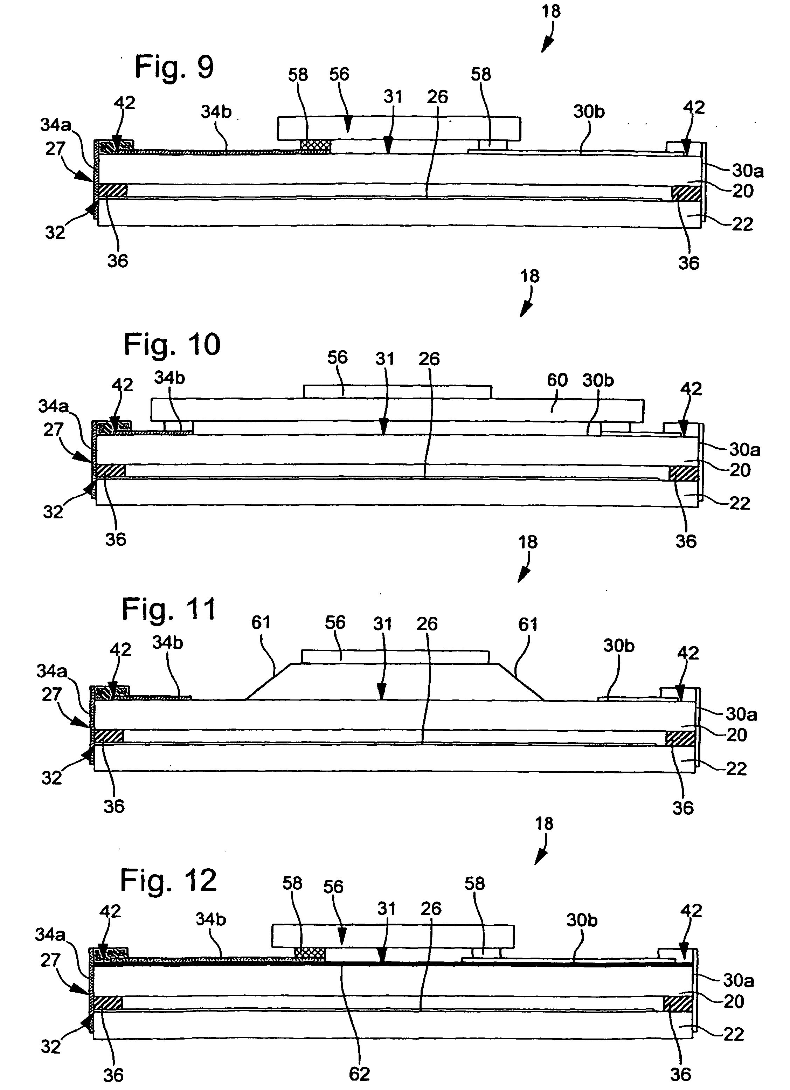

On se réfère maintenant à la figure 9 sur laquelle on voit qu'un circuit intégré 56 de commande de l'affichage est monté directement sur le dos 31 de la cellule d'affichage 18. Dans l'exemple représenté au dessin, le circuit intégré 56 est monté retourné sur la cellule d'affichage 18, technique mieux connue sous sa dénomination anglo-saxonne "flip chip bonding", de sorte que ses ports d'entrée 58 sont collés sur les pistes conductrices 30, 34 de la cellule 18. Bien entendu, selon une variante, les ports d'entrée 58 du circuit intégré 56 pourraient être connectés aux pistes conductrices 30, 34 par de fins fils conducteurs, technique mieux connue sous sa dénomination anglo-saxonne "wire bonding".

Ainsi, grâce à ces caractéristiques, toutes les opérations de solidarisation du circuit intégré de commande de l'affichage se font dans un même plan de travail, à savoir la face arrière 31 de la cellule d'affichage, ce qui simplifie notablement la fabrication d'un tel ensemble. On notera, par ailleurs, que la cellule d'affichage 18 fournit au circuit de commande 56 un support mécanique très stable. On notera enfin que, grâce à l'invention, il est possible de n'utiliser qu'un seul circuit intégré pour la commande à la fois des électrodes de lignes et de colonnes.

Selon une variante de réalisation de l'invention représentée à la figure 10, le circuit intégré de commande 56 est monté sur le dos 31 de la cellule d'affichage à cristal liquide 18 non pas directement, mais par l'intermédiaire d'une plaque de circuit imprimé 60.

Selon encore une autre variante de réalisation de l'invention représentée à la figure 11, le circuit intégré de commande 56 est monté sur le dos 31 de la cellule d'affichage à cristal liquide 18 par l'intermédiaire d'un film conducteur souple 61 réalisé en Kapton®, technique mieux connue sous sa dénomination anglo-saxonne "Tape automatic bonding" ou TAB.

Il va de soi que la présente invention n'est pas limitée aux modes de réalisation qui viennent d'être décrits et que diverses modifications et variantes simples peuvent être envisagées sans sortir du cadre de la présente invention. On peut notamment envisager (voir figure 12) de déposer sur le dos de la cellule à cristal liquide une couche absorbante 62 transparente ou colorée dont les fonctions seront les suivantes :
- absorber la lumière transmise à travers la cellule à cristal liquide;
- faire office de couche de relaxation des contraintes thermo-mécaniques qui apparaissent entre le substrat arrière en verre de la cellule et les pistes conductrices lors du montage à température élevée du circuit de commande sur ledit substrat arrière;
- protéger la cellule, et en particulier le cristal liquide, contre l'irradiation du faisceau laser lors de la structuration des pistes métalliques.

Il faudra en outre que la couche absorbante soit en mesure de résister aux bains d'attaque chimique lors du gravage de la couche métallique sur le dos de la cellule.

On peut également envisager (voir figure 13) de remplacer les plots conducteurs individuels par une bande de matériau conducteur anisotrope 64 qui ne conduirait le courant que dans le sens de la profondeur, c'est-à-dire du bord arrière 40 de la cellule 18 vers le centre de celle-ci et pas transversalement, de façon à ne pas risquer de court-circuiter deux pistes conductrices adjacentes.

## Revendications

1. Cellule d'affichage électro-optique (1; 18), en particulier à cristaux liquides, ou cellule photovoltaïque électrochimique comprenant :
- au moins un substrat avant (2; 22) transparent dont la surface supérieure définit la face avant (14) de la cellule (1; 18);
- au moins un substrat arrière (8; 20) également transparent ou non dont la surface inférieure (12; 31) constitue la face arrière de ladite cellule (1; 18);
- un cadre de scellement (36) réunissant les substrats avant (2; 22) et arrière (8; 20) et délimitant un volume (38) pour le confinement étanche d'un milieu électro-optiquement ou photoélectriquement actif;
- lesdits substrats avant (2; 22) et arrière (8; 20) comportant sur leurs faces en regard au moins une électrode (24, 26) chacun, ces électrodes (24, 26) étant reliées à des pistes conductrices (16: 30, 34) elles-mêmes destinées à être reliées à un circuit électrique d'alimentation ou de commande (10; 56) et définissant des zones de contact électrique latérales (28, 32) aux endroits où elles affleurent la tranche de la cellule,
cette cellule étant **caractérisée en ce que** les pistes conductrices (30, 34) se composent chacune d'une première partie (30a, 34a) en contact avec les électrodes à hauteur des zones de contact électrique latérales (28, 32), et d'une seconde partie (30b, 34b) s'étendant sur la surface arrière (31) de la cellule (18), des moyens de contact (42) ménagés de façon continue ou discontinue le long d'une partie au moins du pourtour arrière (40) de la cellule (1; 18) sur la tranche (27) et/ou sur la face arrière (12; 31) de ladite cellule (1; 18) assurant la jonction électrique entre les premières (30a, 34a) et les deuxièmes parties (30b, 34b) des pistes conductrices (30, 34).

2. Cellule selon la revendication 1, **caractérisée en ce que** les moyens de contact (42) se présentent sous la forme de plots discrets.

3. Cellule selon la revendication 2, **caractérisée en ce que** les premières parties (30a, 34a) des pistes conductrices (30, 34) viennent latéralement en contact avec les plots conducteurs (42), tandis que les secondes parties (30b, 34b) des pistes conductrices (30, 34) peuvent s'étendre jusqu'à la cime desdits plots (42) et les recouvrir en tout ou partie.

4. Cellule selon la revendication 2, **caractérisée en ce que** les secondes parties (30b, 34b) des pistes conductrices s'étendent au moins partiellement sous les plots conducteurs (42).

5. Cellule selon la revendication 1, **caractérisée en ce que** les moyens de contact (42) se présentent sous la forme d'une bande de matériau conducteur anisotrope (64).

6. Cellule selon l'une quelconque des revendications 1 à 5, **caractérisée en ce qu'**elle comprend un empilement de (n) cellules individuelles, chacune des cellules individuelles étant délimitée par deux substrats qui lui sont propres.

7. Cellule selon l'une quelconque des revendications 1 à 5, **caractérisée en ce qu'**elle comprend (n+1) substrats superposés, ces (n+1) substrats étant réunis deux à deux par un cadre de scellement.

8. Cellule selon l'une quelconque des revendications 1 à 7, **caractérisée en ce que** le circuit d'alimentation ou de commande (10; 56) est monté sur la face arrière (12; 31) de la cellule (1; 18).

9. Cellule selon la revendication 8, **caractérisée en ce que** le circuit (10; 56) est monté directement sur la face arrière (12; 31) de la cellule (1; 18).

10. Cellule selon la revendication 8, **caractérisée en ce que** le circuit (10; 56) est monté sur la face arrière (12; 31) de la cellule (1; 18) par l'intermédiaire d'une plaquette de circuit imprimé (60) ou d'un film conducteur souple (61).

11. Cellule selon l'une quelconque des revendications 1 à 10, **caractérisée en ce qu'**une couche absorbante (62) transparente ou colorée permettant une relaxation des contraintes thermo-mécaniques et apte à résister à un bain d'attaque chimique est déposée sur la face arrière de la cellule (18).

## Patentansprüche

1. Elektrooptische Anzeigezelle (1; 18), insbesondere mit Flüssigkristallen, oder elektrochemische photovoltaische Zelle, die umfasst:
- wenigstens ein lichtdurchlässiges vorderes Substrat (2; 22), dessen obere Oberfläche die vordere Fläche (14) der Zelle (1; 18) bildet;
- wenigstens ein hinteres Substrat (8; 22), das ebenfalls lichtdurchlässig oder nicht lichtdurchlässig sein kann, dessen untere Oberfläche (12; 31) die hintere Fläche der Zelle (1; 18) bildet;
- einen Einkapselungsrahmen (36), der das vordere Substrat (2; 22) und das hintere Substrat (8; 20) miteinander vereinigt und ein Volumen (38) für die dichte Einkapselung eines elektrooptisch oder photoelektrisch aktiven Milieus begrenzt;
- wobei das vordere Substrat (2; 22) und das hintere Substrat (8; 20) auf ihren einander zugewandten Flächen wenigstens jeweils eine Elektrode (24, 26) aufweisen, wobei diese Elektroden (24, 26) mit Leiterbahnen (16; 30, 34) verbunden sind, die ihrerseits dazu vorgesehen sind, mit einer elektrischen Versorgungs- oder Steuerschaltung (10; 56) verbunden zu werden, und Zonen (28, 32) für einen seitlichen elektrischen Kontakt an den Stellen, an denen sie mit der Schnittfläche der Zelle bündig sind, definieren,
wobei diese Zelle **dadurch gekennzeichnet ist, dass** die Leiterbahnen (30, 34) jeweils aus einem ersten Teil (30a, 34a), der mit den Elektroden auf Höhe der seitlichen elektrischen Kontaktzonen (28, 32) in Kontakt ist, und aus einem zweiten Teil (30b, 34b), der sich auf der hinteren Oberfläche (31) der Zelle (18) erstreckt, aufgebaut sind, wobei Kontaktmittel (42), die kontinuierlich oder diskontinuierlich wenigstens längs eines Teils des unteren Umfangs (40) der Zelle (1; 18) auf der Schnittfläche (27) und/oder auf der hinteren Fläche (12; 31) der Zelle (1; 18) vorgesehen sind, die elektrische Verbindung zwischen den ersten Teilen (30a, 34a) und den zweiten Teilen (30b, 34b) der Leiterbahnen (30, 34) sicherstellen.

2. Zelle nach Anspruch 1, **dadurch gekennzeichnet, dass** die Kontaktmittel (42) die Form diskreter Anschlussflächen besitzen.

3. Zelle nach Anspruch 2, **dadurch gekennzeichnet, dass** die ersten Teile (30a, 34a) der Leiterbahnen (30, 34) seitlich mit den Leiter-Anschlussflächen (42) in Kontakt gelangen, während die zweiten Teile (30b, 34b) der Leiterbahnen (30, 34) sich bis zur Spitze der Anschlussflächen (42) erstrecken und sie ganz oder teilweise abdecken.

4. Zelle nach Anspruch 2, **dadurch gekennzeichnet, dass** sich die zweiten Teile (30b, 34b) der Leiterbahnen wenigstens teilweise unter den Leiter-Anschlussflächen (42) erstrecken.

5. Zelle nach Anspruch 1, **dadurch gekennzeichnet, dass** die Kontaktmittel (42) die Form eines Streifens (64) aus einem anisotropen leitenden Material haben.

6. Zelle nach einem der Ansprüche 1 bis 5, **dadurch gekennzeichnet, dass** sie einen Stapel aus (n) einzelnen Zellen umfasst, wovon jede durch zwei Substrate begrenzt ist, die ihr gemeinsam sind.

7. Zelle nach einem der Ansprüche 1 bis 5, **dadurch gekennzeichnet, dass** sie (n + 1) übereinander liegende Substrate umfasst, die paarweise durch einen Einkapselungsrahmen miteinander vereinigt sind.

8. Zelle nach einem der Ansprüche 1 bis 7, **dadurch gekennzeichnet, dass** die Versorgungs- oder Steuerschaltung (10; 56) auf der hinteren Fläche (12; 31) der Zelle (1; 18) montiert ist.

9. Zelle nach Anspruch 8, **dadurch gekennzeichnet, dass** die Schaltung (10; 56) direkt auf der hinteren Fläche (12; 31) der Zelle (1; 18) montiert ist.

10. Zelle nach Anspruch 8, **dadurch gekennzeichnet, dass** die Schaltung (10; 56) über eine gedruckte Leiterplatte (60) oder eine biegsame Leiterschicht (61) auf der hinteren Fläche (12; 31) der Zelle (1; 18) montiert ist.

11. Zelle nach einem der Ansprüche 1 bis 10, **dadurch gekennzeichnet, dass** auf der hinteren Fläche der Zelle (18) eine lichtdurchlässige oder gefärbte Absorptionsschicht (62) aufgebracht ist, die eine Lösung thermomechanischer Spannungen ermöglicht und einem chemischen Angriffsbad widerstehen kann.

## Claims

1. Electro-optical display cell (1; 18), particularly a liquid crystal cell, or electrochemical photovoltaic cell comprising:
- at least one transparent front substrate (2; 22) whose top surface defines the front face (14) of the cell (1; 18);
- at least one back substrate (8; 20) that may also be transparent or not, whose lower surface (12; 31) forms the back face of said cell (1; 18);
- a sealing frame (36) joining the front (2, 22) and back (8, 20) substrates and defining a volume (38) for retaining an electro-optically or photo-electrically active medium in a sealed manner;
- said front (2, 22) and back (8, 20) substrates including on their faces opposite each other at least one electrode (24, 26) each, these electrodes (24, 26) being connected to conductive paths (16; 30, 34) themselves intended to be connected to an electrical power or control circuit (10; 56) and defining lateral electric contact zones (28, 32) at the locations where they are flush with the edge of the cell,
said cell being **characterised in that** the conductive paths (30, 34) are each formed of a first part (30a, 34a) in contact with the electrodes at the level of the lateral electric contact zones (28, 32), and a second part (30b, 34b) extending over the back surface (31) of the cell (18), contact means (42) arranged continuously or discontinuously along at least a part of the back periphery (40) of the cell (1; 18) over the edge (27) and/or the back (12; 31) of said cell (1; 18) forming the electrical junction between the first (30a, 34a) and second parts (30b, 34b) of the conductive paths (30, 34).

2. Cell according to claim 1, **characterised in that** the contact means (42) take the form of discrete bumps.

3. Cell according to claim 2, **characterised in that** the first parts (30a, 34a) of the conductive paths (30, 34) come into lateral contact with the conductive bumps (42), whereas the second parts (30b, 34b) of the conductive paths (30, 34) can extend as far as the top of said bumps (42) and cover them in whole or in part.

4. Cell according to claim 2, **characterised in that** the second parts (30b, 34b) of the conductive paths extend at least partially underneath the conductive bumps (42).

5. Cell according to claim 1, **characterised in that** the contact means (42) take the form of a tape of anisotropic conductive material (64).

6. Cell according to any one of claims 1 to 5, **characterised in that** it includes a stack of (n) individual cells, each of the individual cells being defined by two substrates belonging thereto.

7. Cell according to any one of claims 1 to 5, **characterised in that** it includes (n+1) superposed substrates, these (n+1) substrates being joined in pairs by a sealing frame.

8. Cell according to any one of claims 1 to 7, **characterised in that** the power or control circuit (10; 56) is mounted on the back (12; 31) of the cell (1; 18).

9. Cell according to claim 8, **characterised in that** the circuit (10; 56) is mounted directly on the back (12; 31) of the cell (1; 18).

10. Cell according to claim 8, **characterised in that** the circuit (10; 56) is mounted on the back (12; 31) of the cell (1; 18) via a printed circuit board (60) or a flexible conductive film (61).

11. Cell according to any one of claims 1 to 10, **characterised in that** a transparent or coloured absorbent layer (62) for relaxing thermo-mechanical stresses and able to resist a chemical etch bath is deposited on the back of the cell (18).
